# EUROPEAN PATENT APPLICATION

(11) **EP 4 593 087 A1**
(43) Date of publication of application: **30.07.2025**
(21) Application number: 24800746.0
(22) Date of filing: 20.03.2024
(51) Int. Cl.: H01L 29/78, H01L 29/417, H01L 21/336

(54) **SILICON CARBIDE PLANAR MOS DEVICE AND MANUFACTURING METHOD THEREFOR**

(30) Priority: 08.12.2023 CN 202311686672
(71) Applicant: United Nova Technology Co., Ltd., Shaoxing, Zhejiang 312000 (CN)
(72) Inventor: SU, Mengmeng, Shaoxing, Zhejiang 312000 (CN); XIE, Zhiping, Shaoxing, Zhejiang 312000 (CN); LI, Xiao, Shaoxing, Zhejiang 312000 (CN); SHI, Haixiao, Shaoxing, Zhejiang 312000 (CN); LIU, Shuangjuan, Shaoxing, Zhejiang 312000 (CN)
(74) Representative: Kraus & Lederer PartGmbB
(86) International application number: PCT/CN2024/082627
(87) International publication number: WO 2025/118436

(57) **Abstract**

The present invention provides a planar silicon carbide MOS device and a preparation method therefor. In the planar silicon carbide MOS device, a gap on an inner side of a passivation layer is filled with a metal covering layer instead of a polyimide (PI) layer at the gap. The structure increases an effective area of a cell region, and further avoids the PI layer from applying a large stress to the passivation layer at the gap, that is, reduces a stress on the passivation layer on a side wall of the gap, which protects the passivation layer, and alleviates cracking of the passivation layer on the side wall of the gap, thereby optimizing reliability of the planar silicon carbide MOS device.

## Description

### TECHNICAL FIELD

The present invention relates to the field of semiconductor technologies, and in particular, to a planar silicon carbide MOS device and a preparation method therefor.

### BACKGROUND

The silicon carbide material is a typical representative of the third-generation semiconductor materials, and is also one of the most widely used wide bandgap semiconductor materials with the most mature crystal growth technologies and device manufacturing technologies. Compared with a silicon material, the silicon carbide material has a larger bandgap width, a higher thermal conductivity, a higher electron saturation drift velocity, and a critical breakdown electric field 10 times that of the silicon material, making the silicon carbide material a highly desirable semiconductor material in high-temperature, high-frequency, high-power, and radiation-resistant application scenarios.

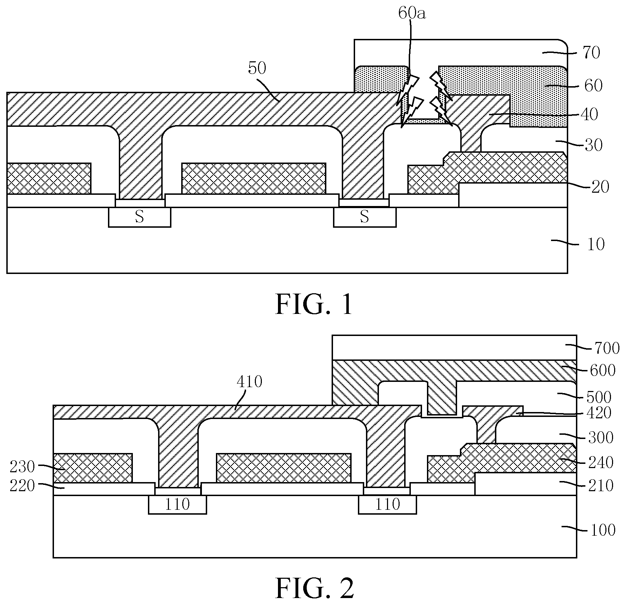

As shown in FIG. 1, an existing planar silicon carbide MOS device includes a gate structure 20 located on a silicon carbide substrate 10, a source region S located in the silicon carbide substrate 10, a dielectric layer 30 covering the gate structure 20 and the silicon carbide substrate 10, and a gate metal layer 40 and a source metal layer 50 covering the dielectric layer 30. The gate structure 20 exposes the source region S, the source metal layer 50 penetrates through the dielectric layer 30 and is in contact with the source region S, and the gate metal layer 40 penetrates through the dielectric layer 30 and is in contact with the gate structure 20. The gate metal layer 40 and the source metal layer 50 are spaced apart, and an etched through hole is provided between the gate metal layer 40 and the source metal layer 50. The planar silicon carbide MOS device further includes a passivation layer (PA layer) 60 and a polyimide (PI) layer 70. The PA layer 60 covers a part of the source metal layer 50, further covers the gate metal layer 40 while further covering a side wall of the etched through hole. The PI layer 70 is located on the PA layer 60 and fills the etched through hole. In the foregoing structure, there is a weak point on an interface between the PI layer 70 and the PA layer 60 on the side wall of the etched through hole. Therefore, the PA layer 60 is prone to cracking and generating cracks 60a, affecting reliability of the planar silicon carbide MOS device. In addition, due to distribution of the source metal layer 50 and the gate metal layer 40, a source pad leading out the source metal layer 50 and a gate pad leading out the gate metal layer 40 are distributed dispersedly.

### SUMMARY

An objective of the present invention is to provide a planar silicon carbide MOS device and a preparation method therefor, to alleviate cracking of a PA layer.

To resolve the foregoing problems, the present invention provides a planar silicon carbide MOS device, including:
a gate structure, located on a silicon carbide substrate;
a source region, located in the silicon carbide substrate and located between two adjacent gate structures;
a dielectric layer, covering the gate structure and the silicon carbide substrate;
a gate metal layer, arranged on the dielectric layer, where the gate metal layer penetrates through the dielectric layer and is in contact with the gate structure;
a source metal layer, arranged on the dielectric layer, where the source metal layer penetrates through the dielectric layer and is in contact with the source region, where a gap is provided between the gate metal layer and the source metal layer;
a passivation layer, covering the gate metal layer, an inner wall of the gap, and the source metal layer near the gap;
a metal covering layer, covering the passivation layer and filling the gap; and
a PI layer, covering the metal covering layer.

Optionally, thicknesses of the source metal layer and the gate metal layer both range from 2 µm to 10 µm.

Optionally, a thickness of the metal covering layer ranges from 2 µm to 10 µm.

Optionally, a material of the metal covering layer is selected from at least one of Al, AlCu, or AlSiCu.

Optionally, the gate structure includes a first gate structure and a second gate structure, where
the first gate structure includes a gate oxide layer and a polysilicon gate, where the gate oxide layer is located on the silicon carbide substrate, and the polysilicon gate is located on the gate oxide layer; and
the second gate structure includes a gate oxide layer, a field oxide layer, and a field plate, where the gate oxide layer and the field oxide layer are adjacent and arranged in contact with the silicon carbide substrate, and the field plate is located on the gate oxide layer and at least a part of the field oxide layer.

Further, the gate metal layer is located above the second gate structure, penetrates through the dielectric layer, and is in contact with the field plate; and the source metal layer is located above the first gate structure and the source region, penetrates through the dielectric layer, and is in contact with the silicon carbide substrate of the source region, where
the gap is located above the second gate structure.

Further, the metal covering layer further covers the source metal layer near the second gate structure, to cause the metal covering layer to be in communication with the source metal layer on an outer side of the passivation layer.

According to another aspect, the present invention further provides a preparation method for a planar silicon carbide MOS device, including the following steps:
providing a silicon carbide substrate, where a source region is formed in the silicon carbide substrate, a gate structure and a dielectric layer covering the gate structure and the silicon carbide substrate are formed on the silicon carbide substrate, a first through hole and a second through hole are formed in the dielectric layer, the first through hole exposes the gate structure, and the second through hole exposes the silicon carbide substrate of the source region;
forming a gate metal layer and a source metal layer simultaneously, where both the gate metal layer and the source metal layer are located on the dielectric layer, the gate metal layer fills the first through hole, and is in contact with the gate structure, and the source metal layer fills the second through hole, and is in contact with the source region, where a gap is provided between the gate metal layer and the source metal layer;
forming a passivation layer, and forming a third through hole in the passivation layer, where the passivation layer covers the gate metal layer, an inner wall of the gap, and the source metal layer near the gap, and the third through hole is located on an inner side of the gap; and
forming a metal covering layer and a PI layer sequentially, where the metal covering layer covers the passivation layer and fills the third through hole, and the PI layer covers the metal covering layer.

Optionally, a method for forming the gate metal layer and the source metal layer simultaneously includes:
forming a metal film layer on the dielectric layer, where the metal film layer covers the dielectric layer, and the metal film layer further fills the first through hole and the second through hole; and
etching the metal film layer through an etching process to form the gate metal layer and the source metal layer, where the gate metal layer is in contact with the gate structure, and the source metal layer is in contact with the source region, and simultaneously forming the gap separating the gate metal layer and the source metal layer.

Optionally, a first spacing is included between a side wall of the third through hole and a side wall of the gap, and a second spacing is included between a bottom wall of the third through hole and a bottom wall of the gap.

Optionally, thicknesses of the source metal layer and the gate metal layer both range from 2 µm to 10 µm.

Optionally, a thickness of the metal covering layer ranges from 2 µm to 10 µm.

Optionally, a material of the metal covering layer is selected from at least one of Al, AlCu, or AlSiCu.

Optionally, the metal covering layer further covers the source metal layer near the passivation layer, to cause the metal covering layer to be in communication with the source metal layer on an outer side of the passivation layer.

Compared with the related art, the present invention has the following beneficial effects:
The present invention provides a planar silicon carbide MOS device and a preparation method therefor. The planar silicon carbide MOS device includes a silicon carbide substrate, a source region, a gate structure, a dielectric layer, a gate metal layer, a source metal layer, a passivation layer, a metal covering layer, and a PI layer. The source region is located in the silicon carbide substrate, the gate structure is located on the silicon carbide substrate, the source region is located between two adjacent gate structures. The dielectric layer covers the gate structure and the silicon carbide substrate, the gate metal layer and the source metal layer are simultaneously arranged on the dielectric layer, and a gap is included between the gate metal layer and the source metal layer. The gate metal layer penetrates through the dielectric layer and is in contact with the gate structure, and the source metal layer penetrates through the dielectric layer and is in contact with the source region. The passivation layer covers the gate metal layer, inner walls (that is, a side wall and a bottom wall) of the gap, and the source metal layer near the gap, the metal covering layer covers the passivation layer and fills the gap, and the PI layer covers the metal covering layer. In the present invention, in the planar silicon carbide MOS device, a gap on an inner side of a passivation layer is filled with a metal covering layer instead of a PI layer at the gap. The structure increases an effective area of a cell region, and further avoids the PI layer from applying a large stress to the passivation layer at the gap, that is, reduces a stress on the passivation layer on a side wall of the gap, which protects the passivation layer, and alleviates cracking of the passivation layer on the side wall of the gap, thereby optimizing reliability of the planar silicon carbide MOS device.

### BRIEF DESCRIPTION OF THE DRAWINGS

FIG. 1 is a schematic cross-sectional structural diagram of a planar silicon carbide MOS device;
FIG. 2 is a schematic cross-sectional structural diagram of a planar silicon carbide MOS device according to an embodiment of the present invention;
FIG. 3 is a schematic flowchart of a preparation method for a planar silicon carbide MOS device according to an embodiment of the present invention;
FIG. 4 is a schematic cross-sectional structural diagram of a silicon carbide substrate according to an embodiment of the present invention;
FIG. 5 is a schematic cross-sectional structural diagram after a gate metal layer and a source metal layer are formed according to an embodiment of the present invention;
FIG. 6 is a schematic cross-sectional structural diagram after a passivation layer is formed according to an embodiment of the present invention; and
FIG. 7 is a schematic cross-sectional structural diagram after a metal covering layer and a PI layer are formed according to an embodiment of the present invention.

In FIG. 1: 10-silicon carbide substrate; 20-gate structure; 30-dielectric layer; 40-gate metal layer; 50-source metal layer; 60-PA layer; 60a-crack; 70-PI layer;
in FIG. 2 to FIG. 7: 100-silicon carbide substrate; 110-source region; 210-field oxide layer; 220-gate oxide layer; 230-polysilicon gate; 240-field plate; 300-dielectric layer; 310-first through hole; 320-second through hole; 410-source metal layer; 420-gate metal layer; 430-gap; 500-passivation layer; 510-third through hole; 600-metal covering layer; 700-PI layer.

### DETAILED DESCRIPTION

A planar silicon carbide MOS device and a preparation method therefor according to the present invention are further described below in detail. The present invention is described below in more detail with reference to the accompanying drawings, in which preferred embodiments of the present invention are presented. It should be understood that a person skilled in the art may modify the present invention described herein while still achieving the beneficial effects of the present invention. Therefore, the following descriptions should be understood as being widely known to a person skilled in the art, and are not intended to limit the present invention.

For clarity, not all features of actual embodiments are described. In the following descriptions, well-known functions and structures are not described in detail since they may confuse the present invention with unnecessary details. It should be considered that in the development of any actual embodiment, numerous implementation details need to be processed to achieve a specific objective of the developer. For example, one embodiment is changed into another embodiment according to system-related or business-related restrictions. In addition, it should be considered that such development work may be complex and time-consuming, but is merely routines for a person skilled in the art.

To make the objectives and features of the present invention more comprehensible, the following further describes specific implementations of the present invention with reference to the accompanying drawings. It should be noted that the accompanying drawings are all in a very simplified form and are not drawn to accurate scale, but are merely used for convenience and clarity of description of the embodiments of the present invention.

As shown in FIG. 2, the present invention provides a planar silicon carbide MOS device, including a silicon carbide substrate 100, a source region 110, a gate structure, a dielectric layer 300, a gate metal layer 420, a source metal layer 410, a passivation layer 500, a metal covering layer 600, and a PI layer 700. The source region 110 is located in the silicon carbide substrate 100, the gate structure is located on the silicon carbide substrate 100, the source region 110 is located between two adjacent gate structures. The dielectric layer 300 covers the gate structure and the silicon carbide substrate 100, the gate metal layer 420 and the source metal layer 410 are simultaneously arranged on the dielectric layer 300, and a gap 430 is included between the gate metal layer 420 and the source metal layer 410. The gate metal layer 420 penetrates through the dielectric layer 300 and is in contact with the gate structure, and the source metal layer 410 penetrates through the dielectric layer 300 and is in contact with the source region 110. The passivation layer 500 covers the gate metal layer 420, inner walls (that is, a side wall and a bottom wall) of the gap 430, and the source metal layer 410 near the gap 430, the metal covering layer 600 covers the passivation layer 500 and fills the gap 430, and the PI layer 700 covers the metal covering layer 600.

In the planar silicon carbide MOS device of this embodiment, the gap 430 on an inner side of the passivation layer 500 is filled with the metal covering layer 600 instead of the PI layer 700 at the gap 430. The structure increases an effective area of a cell region, and further avoids the PI layer 700 from applying a large stress to the passivation layer 500 at the gap 430, that is, reduces a stress on the passivation layer 500 on a side wall of the gap 430, which protects the passivation layer 500, and alleviates cracking of the passivation layer 500 on the side wall of the gap 430, thereby optimizing reliability of the planar silicon carbide MOS device.

Specifically:
the silicon carbide substrate 100 includes a front surface and a back surface. A plurality of source regions 110 are arranged at intervals in the silicon carbide substrate 100 on the front surface. The source regions 110 may extend from the front surface of the silicon carbide substrate 100 into the silicon carbide substrate 100. A conductivity type of the source region 110 is an N type.

A plurality of gate structures are arranged at intervals on the front surface, the gate structures are located on the silicon carbide substrate 100, and the source regions 110 are each located between two adjacent gate structures. In this embodiment, both the source regions 110 and the gate structures are in strip shapes arranged in parallel.

The gate structure may include a first gate structure and a second gate structure. The first gate structure includes a gate oxide layer 220 and a polysilicon gate 230. The gate oxide layer 220 is located on the silicon carbide substrate 100, and the polysilicon gate 230 is located on the gate oxide layer 220. The second gate structure includes a gate oxide layer 220, a field oxide layer 210, and a field plate 240. The gate oxide layer 220 and the field oxide layer 210 are adjacent and arranged in contact with the silicon carbide substrate 100, and the field plate 240 is located on the gate oxide layer 220 and at least a part of the field oxide layer 210. A material of the field plate 240 is polysilicon. A thickness of the field oxide layer 210 is greater than that of the gate oxide layer 220.

The dielectric layer 300 covers the gate structures and the silicon carbide substrate 100 between adjacent gate structures. A material of the dielectric layer 300 is, for example, an oxide such as silicon dioxide.

The gate metal layer 420 and the source metal layer 410 are arranged on a same layer, and are both located on the dielectric layer 300. The gate metal layer 420 is located above the second gate structure, the gate metal layer 420 penetrates through the dielectric layer 300, and is in contact with the field plate 240. The source metal layer 410 is located above the first gate structure and the source region 110, the source metal layer 410 penetrates through the dielectric layer 300, and is in contact with the silicon carbide substrate 100 of the source region 110.

The gate metal layer 420 and the source metal layer 410 may both be mainly made of metal, and materials thereof may be selected from at least one of Al, AlCu, or AlSiCu. Thicknesses of the gate metal layer 420 and the source metal layer 410 located on the dielectric layer 300 both range from 2 µm to 10 µm. Compared with the thicknesses of the gate metal layer 40 and the source metal layer 50 in the related art, the thicknesses of the gate metal layer 420 and the source metal layer 410 in this embodiment are thinner, which reduces a height of the gap 430, so that a stress on the passivation layer 500 at the gap 430 can be reduced.

A width of the gap 430 between the gate metal layer 420 and the source metal layer 410 ranges from 5 µm to 10 µm. Due to the gap 430, there is no electrical connection between the gate metal layer 420 and the source metal layer 410. In this embodiment, the gap 430 is located above the second gate structure.

The passivation layer 500 covers an inner wall of the gap 430, and in addition, further covers the dielectric layer 300 near the gap 430, the gate metal layer 420, and a part of the source metal layer 410 near the gap 430. A thickness of the passivation layer 500 on a side wall of the gap 430 ranges from 0.1 µm to 2 µm.

In this embodiment, the passivation layer 500 is located above the second gate structure, covers a side wall and a bottom wall of the gap 430, and further covers the gate metal layer 420 and the dielectric layer 300 on the gate structure, and the source metal layer 410 near the gap 430.

The metal covering layer 600 covers the passivation layer 500 and further covers a part of the source metal layer 410 near the second gate structure, so that the metal covering layer 600 is in communication with the source metal layer 410 on an outer side of the passivation layer 500, and the metal covering layer 600 further fills the gap 430 to protect the gap 430. Compared with the related art, because the thicknesses of the gate metal layer 420 and the source metal layer 410 are reduced (that is, the height of the gap 430 is reduced), a step height of the passivation layer 500 at the gap 430 can be reduced, so that the stress on the passivation layer 500 at the gap 430 is reduced, thereby alleviating the phenomenon of cracking of the passivation layer 500 on the side wall of the gap 430.

A thickness of the metal covering layer 600 located on the passivation layer 500 ranges from 2 µm to 10 µm. The metal covering layer 600 may be mainly made of metal, and a material thereof may be selected from at least one of Al, AlCu, or AlSiCu. Since hardness of the metal covering layer 600 is less than hardness of the PI layer 700, when the metal covering layer 600 fills the gap 430, the stress on the passivation layer 500 at the gap 430 can be further reduced, thereby further alleviating the phenomenon of cracking of the passivation layer 500 on the side wall of the gap 430.

The planar silicon carbide MOS device according to this embodiment further includes a gate pad and a source pad. The gate pad is in communication with the gate metal layer 420 from above the gate metal layer 420, and the source pad is indirectly in communication with the source metal layer 410 from above the metal covering layer 600, so that the gate pad and the source pad are centrally distributed above the second gate structure, that is, the gate pad and the source pad are centrally distributed, thereby increasing an effective area of a cell region.

The planar silicon carbide MOS device further includes a drain metal layer. The drain metal layer is located on the back surface.

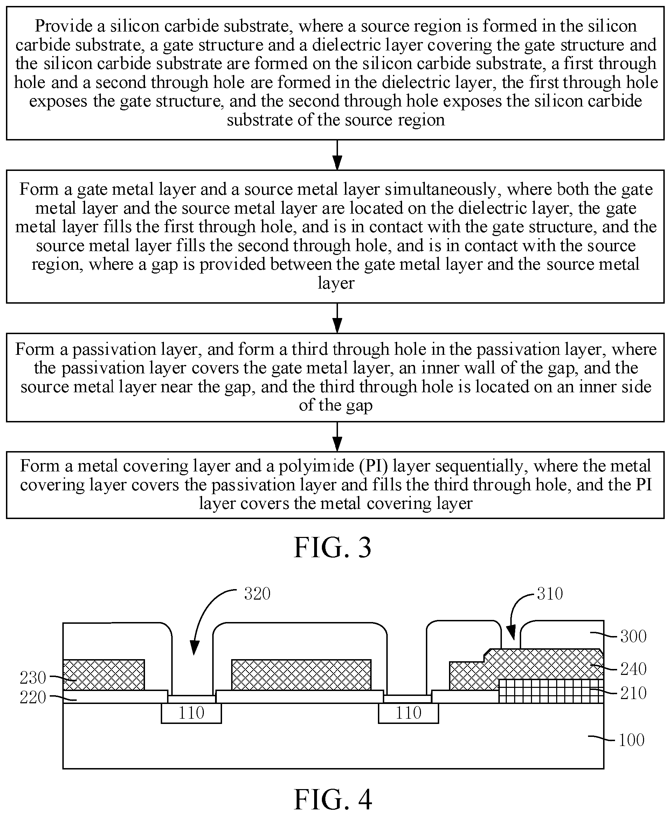

As shown in FIG. 3, this embodiment further provides a preparation method for a planar silicon carbide MOS device, including the following steps:
Step S10: Provide a silicon carbide substrate, where a source region is formed in the silicon carbide substrate, a gate structure and a dielectric layer covering the gate structure and the silicon carbide substrate are formed on the silicon carbide substrate, a first through hole and a second through hole are formed in the dielectric layer, the first through hole exposes the gate structure, and the second through hole exposes the silicon carbide substrate of the source region.

Step S20: Form a gate metal layer and a source metal layer simultaneously, where both the gate metal layer and the source metal layer are located on the dielectric layer, the gate metal layer fills the first through hole, and is in contact with the gate structure, and the source metal layer fills the second through hole, and is in contact with the source region, where a gap is provided between the gate metal layer and the source metal layer.

Step S30: Form a passivation layer, and form a third through hole in the passivation layer, where the passivation layer covers the gate metal layer, an inner wall of the gap, and the source metal layer near the gap, and the third through hole is located on an inner side of the gap.

Step S40: Form a metal covering layer and a PI layer sequentially, where the metal covering layer covers the passivation layer and fills the third through hole, and the PI layer covers the metal covering layer.

As shown in FIG. 4, in step S10, the first through hole 310 exposes the field plate 240 of the second gate structure, and the second through hole 320 exposes the silicon carbide substrate 100 of the source region 110 between two adjacent gate structures. Specifically, the second through hole 320 exposes the silicon carbide substrate 100 of the source region 110 between two adjacent first gate structures and the silicon carbide substrate 100 of the source region 110 between the first gate structure and the second gate structure.

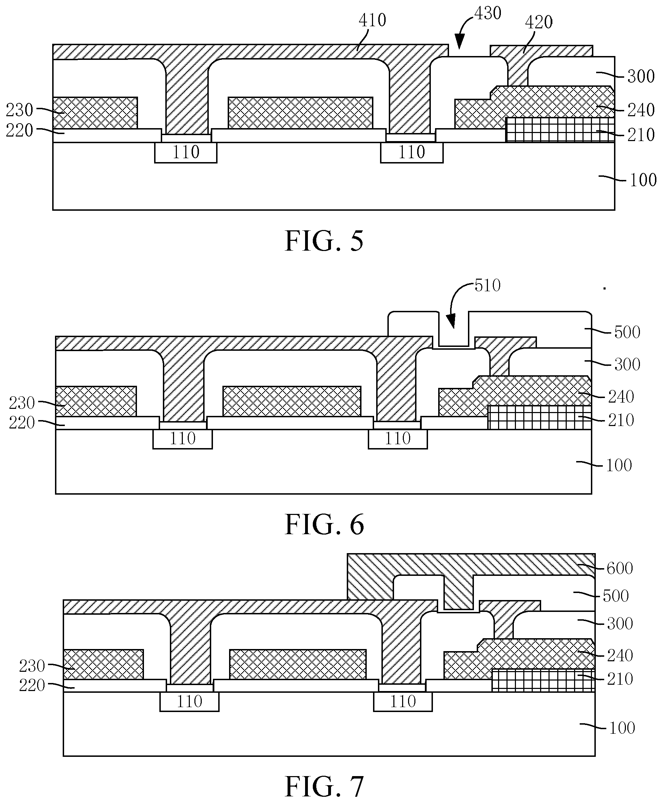

As shown in FIG. 5, step S20 specifically includes the following:
First, a metal film layer is formed on the dielectric layer 300, where the metal film layer covers the dielectric layer 300, and the metal film layer further fills the first through hole 310 and the second through hole 320, so that the metal film layer is in contact with the source region 110 and is further in contact with the field plate 240 of the second gate structure.

Next, the metal film layer is etched through an etching process to form the gate metal layer 420 and the source metal layer 410. In this case, the gate metal layer 420 is in contact with the field plate 240 of the second gate structure, and the source metal layer 410 is in contact with the source region 110. Simultaneously, the gap 430 separating the gate metal layer 420 and the source metal layer 410 is formed on the second gate structure.

As shown in FIG. 6, step S30 includes the following:
First, a passivation layer 500 is formed. The passivation layer 500 covers the gate metal layer 420, an inner wall of the gap 430, and the source metal layer 410 near the gap 430.

Then, a third through hole 510 is formed in the passivation layer 500 through an etching process. The third through hole 510 is located on an inner side of the gap 430. In addition, a first spacing is included between a side wall of the third through hole 510 and a side wall of the gap 430, and a second spacing is included between a bottom wall of the third through hole 510 and a bottom wall of the gap 430, so that the passivation layer 500 on an inner wall at a bottom of the third through hole 510 covers the side wall and the bottom wall of the gap 430. The first spacing may be equal to the second spacing, or the first spacing may not be equal to the second spacing. Preferably, the first spacing may be equal to the second spacing.

Step S40 includes the following:
As shown in FIG. 7, first, a metal covering layer 600 is formed. The metal covering layer 600 fills the third through hole 510, covers the passivation layer 500, and in addition, further covers a part of the source metal layer 410 near the second gate structure, so that the metal covering layer 600 is in communication with the source metal layer 410 on an outer side of the passivation layer 500.

As shown in FIG. 2, a PI layer 700 is formed. The PI layer 700 covers the metal covering layer 600.

In conclusion, the present invention provides a planar silicon carbide MOS device and a preparation method therefor. The planar silicon carbide MOS device includes a silicon carbide substrate, a source region, a gate structure, a dielectric layer, a gate metal layer, a source metal layer, a passivation layer, a metal covering layer, and a PI layer. The source region is located in the silicon carbide substrate, the gate structure is located on the silicon carbide substrate, the source region is located between two adjacent gate structures. The dielectric layer covers the gate structure and the silicon carbide substrate, the gate metal layer and the source metal layer are simultaneously arranged on the dielectric layer, and a gap is included between the gate metal layer and the source metal layer. The gate metal layer penetrates through the dielectric layer and is in contact with the gate structure, and the source metal layer penetrates through the dielectric layer and is in contact with the source region. The passivation layer covers the gate metal layer, inner walls (that is, a side wall and a bottom wall) of the gap, and the source metal layer near the gap, the metal covering layer covers the passivation layer and fills the gap, and the PI layer covers the metal covering layer. In the present invention, in the planar silicon carbide MOS device, a gap on an inner side of a passivation layer is filled with a metal covering layer instead of a PI layer at the gap. The structure increases an effective area of a cell region, and further avoids the PI layer from applying a large stress to the passivation layer at the gap, that is, reduces a stress on the passivation layer on a side wall of the gap, which protects the passivation layer, and alleviates cracking of the passivation layer on the side wall of the gap, thereby optimizing reliability of the planar silicon carbide MOS device.

In addition, it should be noted that, unless otherwise specified or indicated, descriptions of terms "first" and "second" in the specification are merely used to distinguish between components, elements, steps, and the like in the specification, but are not used to represent a logical relationship, a sequential relationship, or the like between the components, elements, and steps.

It may be understood that, although the present invention has been disclosed above through the preferred embodiments, the foregoing embodiments are not intended to limit the present invention. Any person skilled in the art can use the technical content disclosed above to make many possible changes and modifications to the technical solutions of the present invention or make equivalent variations to obtain equivalent embodiments without departing from the scope of the technical solutions of the present invention. Therefore, any simple changes, equivalent variations, and modifications made to the foregoing embodiments according to the technical essence of the present invention without departing from the content of the technical solutions of the present invention shall still fall within the scope of the technical solutions of the present invention.

## Claims

1. A planar silicon carbide MOS device, comprising:
a gate structure, located on a silicon carbide substrate;
a source region, located in the silicon carbide substrate and located between two adjacent gate structures;
a dielectric layer, covering the gate structure and the silicon carbide substrate;
a gate metal layer, arranged on the dielectric layer, wherein the gate metal layer penetrates through the dielectric layer and is in contact with the gate structure;
a source metal layer, arranged on the dielectric layer, wherein the source metal layer penetrates through the dielectric layer and is in contact with the source region, wherein a gap is provided between the gate metal layer and the source metal layer;
a passivation layer, covering the gate metal layer, an inner wall of the gap, and the source metal layer near the gap;
a metal covering layer, covering the passivation layer and filling the gap; and
a polyimide (PI) layer, covering the metal covering layer.

2. The planar silicon carbide MOS device according to claim 1, wherein thicknesses of the source metal layer and the gate metal layer both range from 2 µm to 10 µm.

3. The planar silicon carbide MOS device according to claim 1, wherein a thickness of the metal covering layer ranges from 2 µm to 10 µm.

4. The planar silicon carbide MOS device according to claim 1, wherein a material of the metal covering layer is selected from at least one of Al, AlCu, or AlSiCu.

5. The planar silicon carbide MOS device according to claim 1, wherein the gate structure comprises a first gate structure and a second gate structure, wherein
the first gate structure comprises a gate oxide layer and a polysilicon gate, wherein the gate oxide layer is located on the silicon carbide substrate, and the polysilicon gate is located on the gate oxide layer; and
the second gate structure comprises a gate oxide layer, a field oxide layer, and a field plate, wherein the gate oxide layer and the field oxide layer are adjacent and arranged in contact with the silicon carbide substrate, and the field plate is located on the gate oxide layer and at least a part of the field oxide layer.

6. The planar silicon carbide MOS device according to claim 5, wherein the gate metal layer is located above the second gate structure, penetrates through the dielectric layer, and is in contact with the field plate; and the source metal layer is located above the first gate structure and the source region, penetrates through the dielectric layer, and is in contact with the silicon carbide substrate of the source region,
wherein the gap is located above the second gate structure.

7. The planar silicon carbide MOS device according to claim 5, wherein the metal covering layer further covers the source metal layer near the second gate structure, to cause the metal covering layer to be in communication with the source metal layer on an outer side of the passivation layer.

8. A preparation method for a planar silicon carbide MOS device, comprising the following steps:
providing a silicon carbide substrate, wherein a source region is formed in the silicon carbide substrate, a gate structure and a dielectric layer covering the gate structure and the silicon carbide substrate are formed on the silicon carbide substrate, a first through hole and a second through hole are formed in the dielectric layer, the first through hole exposes the gate structure, and the second through hole exposes the silicon carbide substrate of the source region;
forming a gate metal layer and a source metal layer simultaneously, wherein both the gate metal layer and the source metal layer are located on the dielectric layer, the gate metal layer fills the first through hole, and is in contact with the gate structure, and the source metal layer fills the second through hole, and is in contact with the source region, wherein a gap is provided between the gate metal layer and the source metal layer;
forming a passivation layer, and forming a third through hole in the passivation layer, wherein the passivation layer covers the gate metal layer, an inner wall of the gap, and the source metal layer near the gap, and the third through hole is located on an inner side of the gap; and
forming a metal covering layer and a polyimide (PI) layer sequentially, wherein the metal covering layer covers the passivation layer and fills the third through hole, and the PI layer covers the metal covering layer.

9. The preparation method for a planar silicon carbide MOS device according to claim 8, wherein a method for forming the gate metal layer and the source metal layer simultaneously comprises:
forming a metal film layer on the dielectric layer, wherein the metal film layer covers the dielectric layer, and the metal film layer further fills the first through hole and the second through hole; and
etching the metal film layer through an etching process to form the gate metal layer and the source metal layer, wherein the gate metal layer is in contact with the gate structure, and the source metal layer is in contact with the source region, and simultaneously forming the gap separating the gate metal layer and the source metal layer.

10. The preparation method for a planar silicon carbide MOS device according to claim 8, wherein a first spacing is comprised between a side wall of the third through hole and a side wall of the gap, and a second spacing is comprised between a bottom wall of the third through hole and a bottom wall of the gap.

11. The preparation method for a planar silicon carbide MOS device according to claim 8, wherein thicknesses of the source metal layer and the gate metal layer both range from 2 µm to 10 µm.

12. The preparation method for a planar silicon carbide MOS device according to claim 8, wherein a thickness of the metal covering layer ranges from 2 µm to 10 µm.

13. The preparation method for a planar silicon carbide MOS device according to claim 8, wherein a material of the metal covering layer is selected from at least one of Al, AlCu, or AlSiCu.

14. The preparation method for a planar silicon carbide MOS device according to claim 8, wherein the metal covering layer further covers the source metal layer near the passivation layer, to cause the metal covering layer to be in communication with the source metal layer on an outer side of the passivation layer.

15. The preparation method for a planar silicon carbide MOS device according to claim 10, wherein the first spacing is equal to the second spacing.
